# EUROPEAN PATENT APPLICATION

(11) **EP 4 368 752 A1**
(43) Date of publication of application: **15.05.2024**
(21) Application number: 23206580.5
(22) Date of filing: 30.10.2023
(51) Int. Cl.: C30B 23/02, C30B 23/06, C30B 29/36

(54) **SEMICONDUCTOR CRYSTAL GROWTH USING SOURCE POWDER FROM CRUCIBLE WALL**

(30) Priority: 09.11.2022 US 202218053796
(71) Applicant: Semiconductor Components Industries, LLC, Scottsdale, AZ 85250 (US)
(72) Inventor: JESKO, Radek, 74283 Olbramice (CZ); VALEK, Lukas, 75661 Roznov pod Radhostem (CZ); TESIK, Jan, 75661 Roznov pod Radhostem (CZ)
(74) Representative: Manitz Finsterwald Patent- und Rechtsanwaltspartnerschaft mbB

(57) **Abstract**

A crucible for manufacturing semiconductor crystals may be disposed adjacent to a heating element. The crucible may include a first seed crystal site and a second seed crystal site at opposed ends of the crucible. A compartment may be defined between an outer wall and an inner wall of the crucible, where the inner wall is formed with a porous graphite membrane. Source powder loaded into the compartment may then be heated by the heating element to sublimate and diffuse from the compartment and through the inner wall to provide crystal growth of a first seed crystal at the first seed crystal site and of a second seed crystal at the second seed crystal site.

## Description

### TECHNICAL FIELD

This description relates to manufacture of semiconductor crystals.

### BACKGROUND

Semiconductor crystals are commonly manufactured, e.g., grown from a seed crystal, and sliced to form wafers, which may then be used to form individual semiconductor devices. Multiple techniques have historically been used to grow a semiconductor crystal, such as a Silicon Carbide (SiC) crystal. For example, High Temperature Chemical Vapor Deposition (HTCVD), Liquid-Phase Epitaxy, Solution Growth, and Physical Vapor Transport (PVT) have been used.

### SUMMARY

According to one general aspect, a crucible for manufacturing a semiconductor crystal may include an outer wall, and an inner wall formed using a graphite membrane and defining a compartment between the inner wall and the outer wall, the graphite membrane having a porosity sufficient to enable diffusion of vapor sublimated from source powder disposed within the compartment when the source powder is sublimated by a heating element. The crucible may include a first seed crystal site disposed to receive a first seed crystal, and a second seed crystal site at an opposed end of the crucible from the first seed crystal site and disposed to receive a second seed crystal.

According to another general aspect, a semiconductor manufacturing assembly may include a heating element and a crucible disposed adjacent to the heating element. The crucible may include a first seed crystal site and a second seed crystal site at opposed ends of the crucible, and may include an outer wall. The crucible may include an inner wall formed with a porous graphite membrane, wherein a compartment defined between the outer wall and the inner wall is disposed to receive source powder, which, when heated by the heating element, sublimates and diffuses from the compartment and through the inner wall to provide crystal growth of a first seed crystal at the first seed crystal site and of a second seed crystal at the second seed crystal site.

According to another general aspect, a method of making semiconductor crystals may include loading source powder into a compartment formed between an outer wall and an inner wall of a crucible, the inner wall being formed using a graphite membrane. The method may include heating the source powder with a heating element to sublimate the source powder and thereby cause diffusion of the sublimated source powder through the inner wall and into at least one chamber of the crucible within the inner wall. The method may include monitoring crystal growth within the chamber of a first crystal from a first seed crystal positioned at a first seed crystal site and of a second crystal from a second seed crystal positioned at a second seed crystal site at an opposed end of the crucible from the first seed crystal site.

The details of one or more implementations are set forth in the accompanying drawings and the description below. Other features will be apparent from the description and drawings, and from the claims.

### BRIEF DESCRIPTION OF THE DRAWINGS

FIG. 1 is a cross-sectional view of a device for semiconductor crystal growth.
FIG. 2 is a view of the device of FIG. 1, taken along line A-A.
FIG. 3 is a cross-sectional view of a first implementation of the device for semiconductor crystal growth of FIG. 1.
FIG. 4 is a cross-sectional view of a second implementation of the device for semiconductor crystal growth of FIG. 1.
FIG. 5 is a cross-sectional view of a third implementation of the device for semiconductor crystal growth of FIG. 1.
FIG. 6 is a cross-sectional view of a fourth implementation of the device for semiconductor crystal growth of FIG. 1.
FIG. 7 is a flowchart illustrating an example process flow for manufacturing a semiconductor crystal using one or more of the devices of FIGS. 1-6.

### DETAILED DESCRIPTION

Described techniques may be used to increase a growth capacity and efficiency of a PVT process, and to provide additional flexibility and design options when growing semiconductor crystals. Consequently, production of semiconductor crystals, including SiC crystals, may be increased, and adoption of SiC devices may be improved.

In the PVT method, also known as the sublimation method, SiC powder may be heated to a sublimation temperature using a suitable heating source, such as induction coils. The resulting SiC vapor may then be transported to a seed crystal positioned within a crucible, using a temperature gradient created within the crucible, e.g., by the heating element and a relative positioning of the heating element and the crucible. The SiC vapor may then deposit onto the seed crystal to thereby grow a SiC crystal of desired size and length.

Unfortunately, this process must typically be performed very slowly, in order to ensure that a crystalline structure of the resulting crystal is of sufficient quality. Consequently, a throughput of a typical PVT process is very low. As a result, for example, production of SiC crystals is a limiting factor in the production, adoption, and use of SiC semiconductor devices, despite the many advantageous properties of SiC in forming such devices.

As referenced above, a growth rate of conventional crystal growth processes, e.g., SiC crystal growth processes, is designed to be slow, in order to ensure crystal quality and consistency. For example, a capacity or throughput of conventional processes may be in the range of 4-10mm per week of a 6-inch crystal.

In example implementations, growth capacity may be increased by growing two crystals in a crucible at the same time. Described approaches increase efficiency of crystal growth, for example, by utilizing energy that is typically wasted for growth of a second crystal. Efficiency may be further increased by sharing device components that are typically used for growing a single crystal, so that a single such device component may be leveraged to grow two crystals simultaneously.

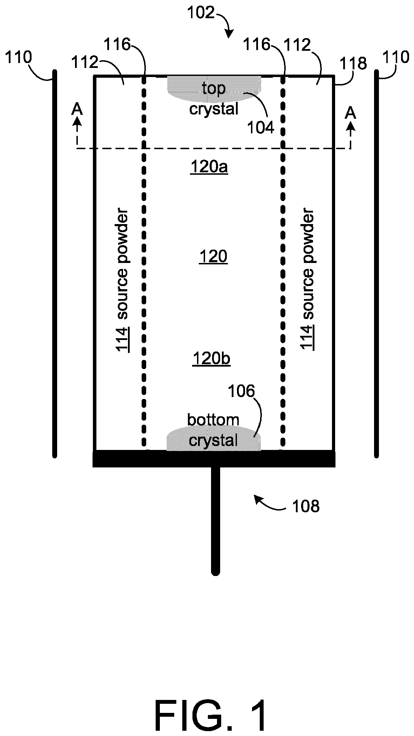

FIG. 1 is a cross-sectional view of a semiconductor manufacturing assembly for semiconductor crystal growth, e.g., as part of a PVT process. In the example of FIG. 1, a crucible 102 may be configured to grow two semiconductor crystals 104, 106 in overlapping (e.g., the same) time frame(s). In the present description, the crucible 102 should be understood to refer to any vessel, chamber, or other container that is suitable for holding, forming, or otherwise manufacturing the semiconductor crystal(s) 104, 106.

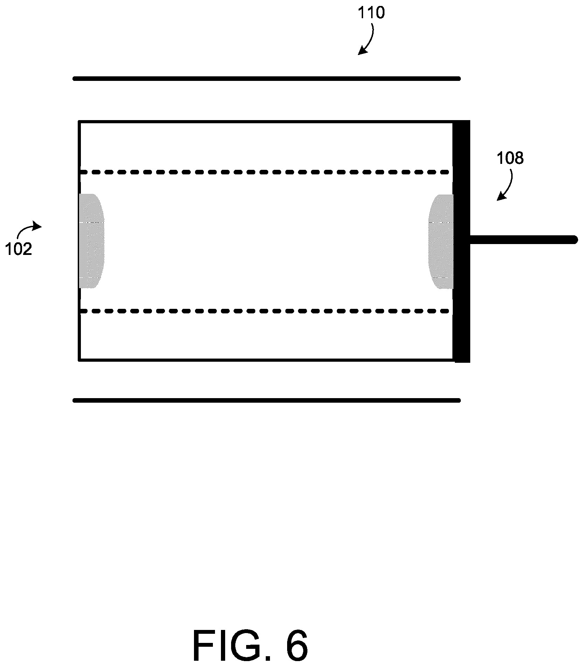

In the example of FIG. 1, the crucible 102 is illustrated in a vertical configuration, so that a first crystal may be referred to as a top crystal 104, formed at a top or first seed crystal site. A second crystal may be referred to as a bottom crystal 106, formed at a bottom or second seed crystal site at an opposed end of the crucible 102 from the first crystal site. However, as shown in FIG. 6, the device of FIG. 1 may also be implemented in other configurations, such as horizontal configurations.

Further in FIG. 1, a support member 108 may be configured to support and position the crucible 102, relative to a heating element 110. For example, the heating element 110 may represent a radio frequency (RF) coil, or a resistive heater.

The crucible 102 is illustrated as a hollow-wall crucible, e.g., a hollow cylinder body, in which a compartment 112 is disposed to receive, contain, or hold source powder 114. A membrane 116 represents a wall of the crucible 102 formed using a porous or semi-porous material, such as porous graphite.

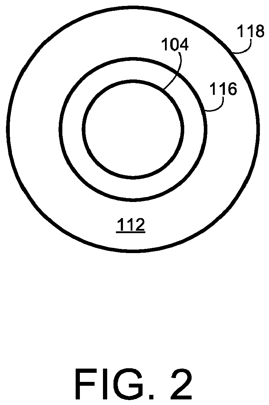

With reference to FIG. 2, taken along line A-A of FIG. 1, the compartment 112 may be formed in a cylindrical or donut shape between an outer wall 118 and the inner wall formed using the membrane 116. In such implementations, as shown in FIG. 2, the top crystal 104, the membrane 116, and the outer wall 118 may be formed concentrically. Other implementations are also possible, e.g., the crucible 102 need not be circular, and may be, e.g., elliptical or oval.

In the example of FIGS. 1 and 2, a chamber or hot zone 120 is formed within the membrane 116, in which both the top crystal 104 and the bottom crystal 106 are grown. In various examples below, an upper portion of the hot zone 120 in which the top crystal 104 is grown may be referred to as an upper chamber or upper hot zone 120a, while a lower portion of the hot zone 120 in which the bottom crystal 106 is grown may be referred to as a lower chamber or lower hot zone 120b.

Using the crucible 102 the support member 108, and heating element 110, a PVT process may be implemented as a sublimation and re-condensation process, in which a temperature gradient is created that sublimates the source powder 114, so that the resulting gas or vapor may diffuse through the porous membrane 116 and be directed within the hot zone 120 to re-condense at both of the top crystal 104 and the bottom crystal 106.

In many conventional systems, source powder may be distributed at least partially within a lower/bottom portion of a crucible, which prevents the lower space from being utilized for crystal growth. Further, when forming a SiC crystal, residual Carbon may form at the lower/bottom portion of a conventional crucible as an unwanted insulator, which at best may waste energy in the form of absorbed heat, and at worst may prevent reaching temperatures needed for desired sublimation to occur.

Other conventional approaches that attempt to avoid the above shortcomings may require pipes or other inlet components to be constructed and positioned within a crucible. Such approaches may be more expensive and more prone to malfunction, and may consume valuable space within a crucible.

Using the device and related techniques of FIG. 1, the source powder 114 may be distributed effectively along an entire length of the crucible wall 118 (and along an entire length of the membrane 116). This approach provides a number of advantages and features, many of which are described below.

For example, by distributing the source powder 114 as just described, source powder close to the crystal levels (e.g., close to a top and bottom of the crucible 102 in FIG. 1) will be heated relatively less by the heating element 110 than source powder close to a middle of the crucible 102 (e.g., when heat from the heating element 110 is concentrated near a middle of the crucible 102). Accordingly, the source powder close to the crystal levels may be used to facilitate establishing a desired temperature gradient within the crucible 102.

In the example of FIG. 1, the illustrated design is symmetrical around center portions in both horizontal and vertical directions. For example, the upper hot zone 120a is essentially the same as the lower hot zone 120b, and the top crystal 104 and the bottom crystal 106 may be grown simultaneously.

As shown and described in various examples herein, such symmetry is not required. For example, adjustments can be made to grow the top crystal 104 and the bottom crystal 106 differently than one another, e.g., at different rates or different qualities. In some examples, as described in more detail, below, the structure of FIG. 1 may be used to produce a single crystal, including, e.g., re-sublimating the bottom crystal 106 to enable additional or continual growth of the top crystal 104.

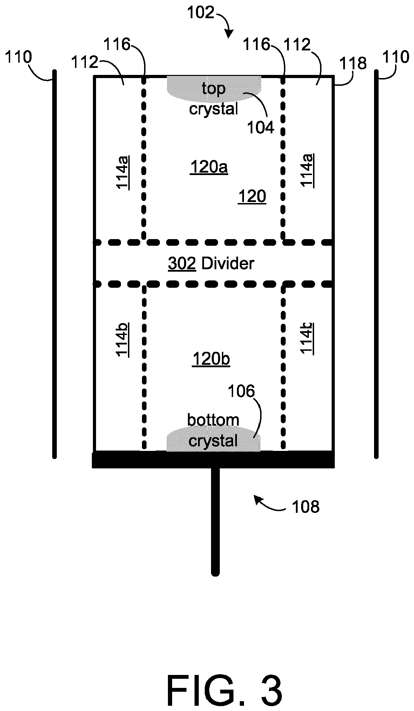

In the example of FIG. 3, a divider 302 may be positioned between the upper hot zone 120a and the lower hot zone 120b. For example, the divider 302 may be a membrane, e.g., a graphite membrane, of relatively low porosity, which prevents vapor sublimated from the source powder 114 from moving between the upper hot zone 120 and the lower hot zone 120b.

The divider 302 may also represent, or be used in conjunction with, a physical division of the upper hot zone 120a from the lower hot zone 120b. That is, the crucible 102 may be physically capable of being separated into two separate crucible components, using, e.g., a threaded connection for screwing the two crucible components together, or using magnetized surfaces, glue, or other joining/separation techniques. In this way, a first crucible portion (e.g., upper crucible portion) and a second crucible portion (e.g., lower crucible portion) may be defined.

Consequently, for example, the top crystal 104 and the bottom crystal 106 may be grown relatively independently of one another. For example, if one of the top crystal 104 or the bottom crystal 106 experiences a defect, the crucible 102 may be separated and the defective crystal may be removed. The crucible 102 may then be re-joined and sealed so that crystal growth may continue.

In these and other examples, the source powder 114 may be physically separated by the divider 302, as well. For example, the source powder 114 may be separated into upper source powder 114a and lower source powder 114b, as shown. Therefore, when the crucible 102 is separated, the upper source powder 114a or the lower source powder 114b may be independently replaced.

For example, if the bottom crystal 106 were found to be defective, the lower portion of the crucible 102 may be separated, and the defective crystal may be removed as noted above. Then, the lower source powder 114b may be replaced so that the lower crucible portion may be re-attached.

In the example of FIG. 3, the divider 302 may include both the low porosity material separating the upper hot zone 120a from the lower hot zone 120b, and the physical divider or separation mechanism described above. In other examples, the divider 302 may include only the physical divider/separation mechanism, without requiring the low porosity material.

In such examples, the implementation of FIG. 3 may be used to grow a single crystal. For example, in the examples above in which the lower crucible portion is removed to remove a defective or low quality bottom crystal 106, processing may continue by replenishing the lower source powder 114b and then continuing (e.g., finishing) growth of only the top crystal 104. In such cases, the top crystal 104 may be grown to a greater length than in scenarios in which the top crystal 104 and the bottom crystal 106 are grown together.

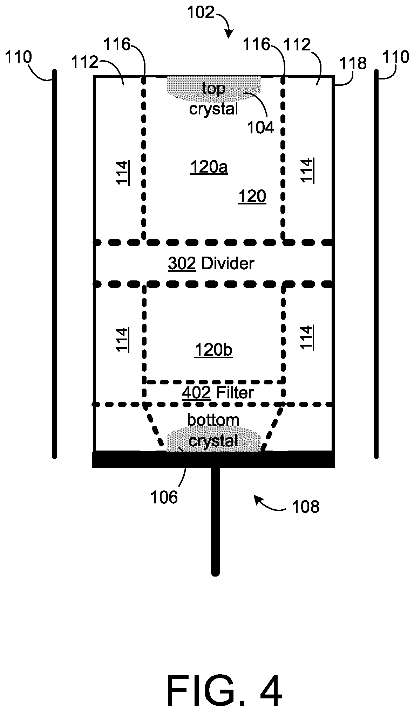

In the example of FIG. 4, a high porosity filter 402 is included and positioned above the bottom crystal 106. For example, the filter 402 may represent a graphite membrane of sufficiently high porosity to permit passage of vapor sublimated from the source powder 114 that facilitate growth of the bottom crystal 106, while filtering any particles (e.g., from the membrane 116). Thus, the filter 402 may be useful in preventing any particles that may be present within the lower hot zone 120b from descending onto the bottom crystal 106, which might otherwise impair a growth process and resulting quality of the bottom crystal 106.

In more detail, the horizontal porous graphite membrane of the filter 402 may be highly permeable for the process vapor species, and prevents deposition of particles born in the gas enclosure or released from graphite walls. Any vapors leaving a bottom surface of the porous membrane of the filter 402 will generally have already reacted with other graphite surfaces and do not react with the bottom surface, so that new particles are not formed that could fall down onto the bottom crystal 106.

The filter 402 may have other advantageous features. For example, the filter 402, depending on its chosen thickness and positioning with respect to the bottom crystal 106, may influence a gas composition and temperature field near the bottom crystal 106.

The example of FIG. 4 illustrates the filter 402 being used in conjunction with the divider 302 of FIG. 3. However, it will be appreciated that, in other example embodiments, the filter 402 may be used without the divider 302. For example, the filter 402 may be included in the implementation of FIG. 1.

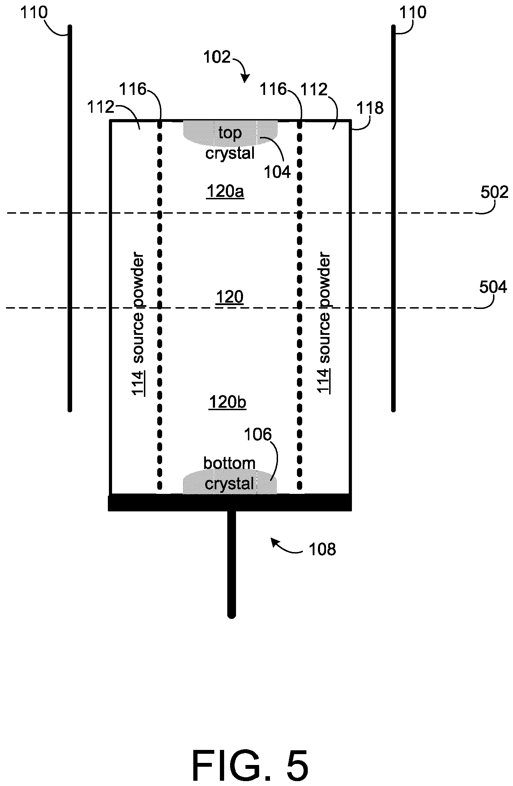

With reference to FIG. 5, as mentioned above, a temperature gradient of heat provided by the heating element 110 is a primary means of control for directing the sublimated source powder to seed crystals to thereby grow the top crystal 104 and the bottom crystal 106. For example, a negative temperature gradient from the source powder 114 to the top crystal 104 and to the bottom crystal 106 may be established of, e.g., approximately 5 C/cm.

For example, when the crucible 102 is placed inside a resistive or RF coil heater as the heating element 110, a temperature inside the crucible 102 decreases with distance from a vertical center of the heating element 110, e.g., from an axis or plane of symmetry 502. In the embodiments of FIGS. 1-4, a corresponding axis or plane of symmetry 504 of the crucible 102 may be aligned with the plane of symmetry 502 of the heating element 110, so that the negative temperature gradient is also symmetrical with respect to the top crystal 104 and the bottom crystal 106 within the crucible 102.

In the example of FIG. 5, however, as shown, the plane of symmetry 502 of the heating element 110 is offset from the plane of symmetry 504 of the crucible 102. Accordingly, a temperature gradient within the crucible 102 will be different than in the examples of FIGS. 1-4, enabling different or additional aspects of control with respect to growing the top crystal 104 and/or the bottom crystal 106.

For example, in some implementations, additional components or elements included in the crucible design, such as a support pillar or additional insulation (not shown in FIG. 5) may influence a temperature distribution within the crucible 102, and may negatively affect a desired temperature gradient. Offsetting the planes of symmetry 502, 504 as shown in FIG. 5 may negate such effects, so that the non-symmetric design of FIG. 5 enables symmetric growth of the top crystal 104 and the bottom crystal 106.

In other example implementations, however, non-symmetric growth of the top crystal 104 and the bottom crystal 106 may be desired. For example, as referenced above, the bottom crystal 106 may be determined to be defective, and growth of the top crystal 104 may thereafter be prioritized, so that a temperature gradient within the crucible 102 may be adjusted accordingly.

Additionally, or alternatively, the bottom crystal 106 may be used as part of techniques to grow the top crystal 104 longer and/or or wider in diameter. For example, as referenced above, the bottom crystal 106 may be re-sublimated to enable additional, continuous growth of the top crystal 104.

In some implementations, vapor formed from source powder 114b may travel to the upper hot zone 120a, and vapor formed from source powder 114a may travel to the lower hot zone 120b. By adjusting the planes of symmetry 502, 504, source powder 114a may be consumed relatively faster than source powder 114b.

Thus, in some implementations, the position of the heating element 110 may be adjusted to consume the source powder 114b adjacent to the lower hot zone 120b faster than the source powder 114b adjacent to the upper hot zone 120a. Then, using the techniques described above with respect to FIGS. 3 and 4, a lower portion of the crucible 102 may be removed so that the source powder 114b may be replenished, whereupon the lower portion of the crucible 102 may be re-attached to the upper portion of the crucible 102 and crystal growth may continue.

In the example of FIG. 6, the crucible 102 and the heating element 110 are rotated ninety degrees from the examples of FIGS. 1-5, so that the crucible 102 and the heating element 110 are placed horizontally. Advantageously in such implementations, fall of debris on a seed growth surface(s) of either the top crystal 104 or the bottom crystal 106 is minimized, without a need, e.g., for the filter 402 of FIG. 4. For example, debris may include graphite particles from any of the graphite surfaces or materials, such as the membrane 116, the divider 302, or the filter 402.

In other examples, various support or other structures may be included within the crucible 102. For example, a support structure for one or both of the top crystal 104 and/or the bottom crystal 106 may be included. Such support structures may also be formed using graphite, and may therefore also be a potential source of graphite debris.

As described herein, growth of semiconductor crystals by the PVT method, particularly SiC crystals, is undesirably slow. Described techniques may increase, e.g., potentially double, a capacity/throughput of conventional techniques, while also increasing an efficiency of the process.

For example, efficiency may be increased by utilizing energy that is typically wasted into bottom insulation in conventional techniques for growth of a second crystal. The efficiency may also be increased by sharing consumable parts (e.g., support structures or insulation) for growth of two crystals instead of one. Described techniques also provide improved power utilization by virtue of the simultaneous crystal growth described herein (e.g., energy savings per unit of crystal produced).

In addition to increased efficiency, described techniques provide additional flexibifity in the design and implementation of semiconductor crystals. For example, two crystals may be grown together, either in the very same manner or with varying growth conditions.

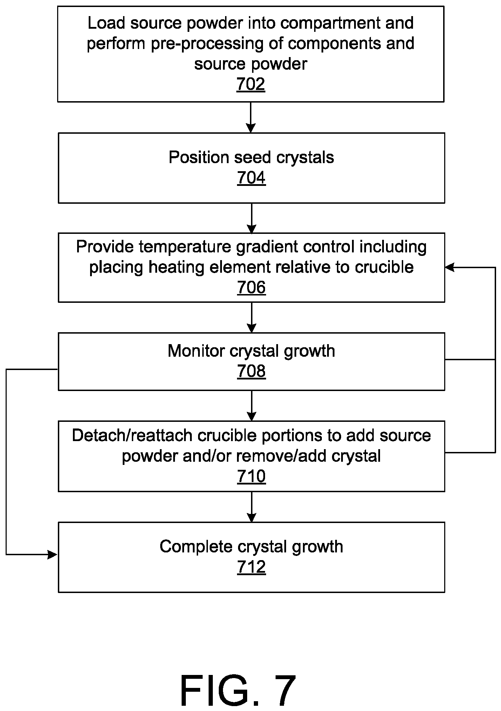

FIG. 7 is a flowchart illustrating an example process flow for manufacturing a semiconductor crystal using one or more of the devices of FIGS. 1-6. In the example of FIG. 7, source powder may be loaded into a compartment of a hollow wall of a crucible, and pre-processing of components of the crucible, and of the source powder, may be performed (702).

For example, pre-processing of crucible components (e.g., seed crystal support structures, or source powder accommodation structures) may include a temperature treatment of crucible components, e.g., in the lower hot zone 120b. Such a temperature treatment may be used to purify the crucible components and ensure that any potential impurities have been released and removed prior to initiation of crystal growth.

For example, PVT processes are conducted at high temperatures (e.g., 2000 degres C or higher), and some graphite components may not have been sufficiently purified (e.g., may not have been exposed to sufficiently high temperatures) during their manufacture/production. During some pre-processing steps, such crucible components may be exposed to temperaures corresponding to expected temperatures to be used in a PVT process, e.g., by running the process dry, i.e., without a seed crystal or source powder being present.

Consequently, any impurities may be flushed out in a single pre-processing step, without damaging either the crucible components or a seed crystal. In example implementations, a transition from conducting such pre-procesing to crystal growth processing may be straightforward, e.g., by separating the crucible 102 using the divider 302 as described above to provide additional source powder and/or install a seed crystal(s).

Similarly, a source powder treatment may be conducted to ensure a quality of the source powder. For example, some source powder may include varying amounts of silica and free graphite particles, which may decrease a quality of crystals to be grown. By executing a high temperature process with the source powder present but without any seed crystal present in a corresponding hot zone, it is possible to remove such impurities from the source powder. Another reason for the powder pre-processing may be the intention to modify the stoichiometry of the process gasses at the beginning of the crystal growth. The stoichiometry is a function of, among others, powder state. As with the heat treatment of crucible components as just referenced, it is then straightforward to transition the crucible from a source powder treatment stage to a crystal growth stage.

Once pre-processing is completed, the seed crystals may be placed (704). The seed crystals may be fixed inside the crucible by any functional way. For example, the seed crystal may be glued to a graphite seed holder placed above the seed for the top crystal, or is placed on a graphite seed holder and supported from the bottom at the seed edge for the bottom crystal. Advantageously, the bottom seed crystal is not required to be glued to be held in place.

Temperature gradient control may be provided, including placing a heating element around, and with a desired relative positioning with respect to, the crucible (706). For example, the heating element may be placed symmetrically around the crucible as shown in FIG. 1 for growing two crystals of the same size simultaneously.

Crystal growth may be monitored (708). For example, crystal growth may be monitored for crystal defects. In some examples, as shown in FIG. 7, a control loop may be initiated in which temperature gradient control is used in response to the crystal monitoring, e.g., in order to control relative growth rates, sizes, or proportions of the two crystals being grown.

In other examples, it may occur that two crystals are initially grown symmetrically. Then, the heating element and/or crucible may be shifted relative to one another. In this way, for example, a bottom crystal may be sublimated to serve as a source of growth for a top crystal.

In some examples, if monitoring shows that crystal growth has been completed, the process may end (712). In other examples, crucible portions may be detached and reattached to add source powder and/or remove and/or add a crystal (710). For example, as noted above, depleted source powder may be replaced in order to enable continued growth of a longer crystal(s).

The process(es) of FIG. 7 enable many different crystal growth techniques and outcomes. For example, it is possible to grow a 6 inch diameter crystal and an 8 inch diameter crystal together. In other examples, it is possible to continuously change a diameter of a growing crystal, as it grows. For example, a crystal may initially be grown as a 6 inch crystal, but may be expanded to an 8 inch diameter as crystal growth progresses.

As described herein, a membrane of porous or permeable graphite (e.g., the membrane 116 of FIG. 1) may be used to form a hollow wall to contain source powder in a crucible, and to enable or cause diffusion of the sublimated source powder through the crucible walls (e.g., from a source powder compartment). Porous graphite may also be used as a divider between two hot zone regions of the crucible, such as the divider 302 of FIG. 3, or as a filter to protect a lower crystal, as shown by the filter 402 of FIG. 4.

To enable and provide these and related functions, the parameters of the porous graphite materials may be selected appropriately. Graphite parameters to be selected may include, e.g., porosity, density, grade, thickness, and/or pore size.

Similarly, other graphite elements may be designed and used to affect distribution of gas stoichiometry, temperature, heat fluxes and temperature gradients. All such hot zone constituents may be designed in combination with other process parameters. Such process parameters may include, e.g., temperature on the seed, which may be 2000-2300°C, process pressure (e.g., 0.1 - 10 mbar), composition of the process gas determined by pressure, temperature, source powder properties, and pre-processing treatments as described above). Processing parameters may also include a design of the heating element (e.g., a heating coil that may be single element spiral vs. multiple spiral segments, and having a desired diameter, height, and frequency), as well as a position of the crucible with respect to the heating coil (e.g., in a vertical orientation, a top of the crucible may be set at a designated height above coil center). Accordingly, for example, a SiC crystal of desirable polytype (e.g., 4H) and quality (e.g., dislocation density) may be grown by a desired growth rate (e.g., 100-300 um/hr) on a seed crystal.

In more specific example implementations, high porosity graphite (e.g., >0.4) may be used to build the membrane walls of described crucibles (e.g., the membrane 116 of the crucible 102). The wall thickness may be set to be thin enough (e.g., 2-5 mm) to allow efficient transport of vapors through it. Crystal growth rate may be calculated in part based on the wall thickness.

A weight of source powder that may be used in various implementations may be in a range, e.g., of 3-10 kg. Described implementations may support these levels of source powder weight through the use of the described hollow cylinder of the crucible 102, which enables thin walls while at the same time decreasing a load on the porous graphite material, e.g., of the membrane 116.

As described above, a vertical position of the crucible with respect to the vertical plane of symmetry of the heater may be used to establish a desired axial (e.g., vertical) temperature gradient. Therefore, the hot zone may be designed, and the crucible placed, so that the desired axial temperature gradient is achieved for both the crystals being grown. Any support pillar (e.g., support member 108 of FIG. 1) holding the assembly in place, and its properties, should be accounted for in the hot zone design, and may lead to non-symmetric design for symmetric growth. The need for such adjustments may be avoided by placing a radial symmetry axis of the assembly and heater element horizontally, as shown in FIG. 6. Another non-symmetry which may need compensation arises from the use of a pyrometer peep hole, which may be located on one side of the crucible, e.g., on the top of the crucible.

Upper and lower crucible chambers may be separated by a wall or other divider of low permeability (e.g., < 0.3 cm2/s) for the gas vapors, such as the divider 302 of FIG. 3. In this way, the two chambers do not compete for the gas vapors originating from a central region of the crucible. An example material for the divider 302 includes a high-density (e.g., > 1.7 g/cm3), low-porosity (e.g., <15%) isostatic graphite.

In these implementations, as also described above, the upper and lower process chambers may be made of two separate parts. The facing walls of these parts may then serve as a separation wall. These two chambers may be placed one on top of the other, or may be physically joined, e.g., by a glue or thread.

Described techniques enable enhancement of a productivity, capacity, and throughput of a PVT crucible, e.g., by growing two crystals during a single process run. The described dual growth process may be implemented to yield approximately a same size of the crystal as a conventional single crystal process, with source powder located in a limited volume around a central part of a heating element. Accordingly, an amount of material produced per unit of time and space (layout) may be up to doubled. Moreover, any graphite or insulating materials that may be consumed during the crystal growth may be used in a cost-effective manner, because such materials may be consumed for growth of two crystals, rather than just one.

In a first example implementation, referred to herein as Example 1, a crucible for manufacturing a semiconductor crystal comprises:
an outer wall;
an inner wall formed using a graphite membrane and defining a compartment between the inner wall and the outer wall, the graphite membrane having a porosity sufficient to enable diffusion of vapor sublimated from source powder disposed within the compartment when the source powder is sublimated by a heating element;
a first seed crystal site disposed to receive a first seed crystal; and
a second seed crystal site at an opposed end of the crucible from the first seed crystal site and disposed to receive a second seed crystal.

Example 2 includes the crucible of Example 1, comprising:
a graphite filter within the crucible and positioned above the second seed crystal site when the crucible has a vertical orientation and the second seed crystal site is at a bottom of the crucible.

Example 3 includes the crucible of Example 1, comprising:
a divider configured to separate the crucible into a first crucible portion and a second crucible portion.

Example 4 includes the crucible of Example 3, wherein the divider includes a graphite membrane having a porosity that does not permit passage of the vapor between the first crucible portion and the second crucible portion.

Example 5 includes the crucible of Example 3, wherein the crucible is detachable at the divider into a first crucible portion including the first seed crystal site and a second crucible portion including the second seed crystal site.

Example 6 includes the crucible of Example 1, wherein the crucible is cylindrical.

In a seventh example implementation, referred to herein as Example 7, a semiconductor manufacturing assembly, comprises:
a heating element; and
a crucible disposed adjacent to the heating element and including a first seed crystal site and a second seed crystal site at opposed ends of the crucible, the crucible including an outer wall, the crucible further including an inner wall formed with a porous graphite membrane, wherein a compartment defined between the outer wall and the inner wall is disposed to receive source powder, which, when heated by the heating element, sublimates and diffuses from the compartment and through the inner wall to provide crystal growth of a first seed crystal at the first seed crystal site and of a second seed crystal at the second seed crystal site.

Example 8 includes the semiconductor manufacturing assembly of Example 7, wherein the heating element includes a radio frequency (RF) coil, and the crucible is disposed within the RF coil.

Example 9 includes the semiconductor manufacturing assembly of claim 7, wherein the crucible is disposed vertically within the heating element.

Example 10 includes the semiconductor manufacturing assembly of claim 9, wherein the second seed crystal site is positioned at a bottom of the crucible, and comprising:
a graphite filter positioned above the second seed crystal.

Example 11 includes the semiconductor manufacturing assembly of Example 7, wherein the crucible is disposed horizontally within the heating element.

Example 12 includes the semiconductor manufacturing assembly of Example 7, comprising:
a divider configured to separate the crucible into a first crucible portion and a second crucible portion.

Example 13 includes the semiconductor manufacturing assembly of Example 12, wherein the divider includes a graphite membrane having a porosity that does not permit passage of vapor sublimated from the source powder between the first crucible portion and the second crucible portion.

Example 14 includes the semiconductor manufacturing assembly of Example 12, wherein the crucible is detachable at the divider into a first crucible portion including the first seed crystal site and a second crucible portion including the second seed crystal site.

Example 15 includes the semiconductor manufacturing assembly of claim 7, wherein the crucible is cylindrical.

Example 16 includes the semiconductor manufacturing assembly of claim 7, comprising:
a support member positioned to support the crucible and configured to move the crucible relative to the heating element, to thereby control a temperature gradient within the crucible that occurs in response to heating provided by the heating element.

In a seventeenth example implementation, referred to herein as Example 17, a method of making semiconductor crystals comprises:
loading source powder into a compartment formed between an outer wall and an inner wall of a crucible, the inner wall being formed using a graphite membrane;
heating the source powder with a heating element to sublimate the source powder and thereby cause diffusion of the sublimated source powder through the inner wall and into at least one chamber of the crucible within the inner wall; and
monitoring crystal growth within the chamber of a first crystal from a first seed crystal positioned at a first seed crystal site and of a second crystal from a second seed crystal positioned at a second seed crystal site at an opposed end of the crucible from the first seed crystal site.

Example 18 includes the method of Example 17, further comprising:
detaching a first crucible portion including the first seed crystal site from a second crucible portion including the second seed crystal site; and
loading additional source powder within a portion of the compartment included in the second crucible portion.

Example 19 includes the method of Example 17, further comprising:
moving the crucible and/or the heating element relative to one another to control a temperature gradient within the crucible.

Example 20 includes the method of Example 17, further comprising:
adjusting a temperature gradient within the crucible to re-sublimate the second crystal and enable continued growth of the first crystal.

It will be understood that, in the foregoing description, when an element, such as a layer, a region, a substrate, or component is referred to as being on, connected to, electrically connected to, coupled to, or electrically coupled to another element, it may be directly on, connected or coupled to the other element, or one or more intervening elements may be present. In contrast, when an element is referred to as being directly on, directly connected to or directly coupled to another element or layer, there are no intervening elements or layers present. Although the terms directly on, directly connected to, or directly coupled to may not be used throughout the detailed description, elements that are shown as being directly on, directly connected or directly coupled can be referred to as such. The claims of the application, if any, may be amended to recite exemplary relationships described in the specification or shown in the figures.

As used in the specification and claims, a singular form may, unless definitely indicating a particular case in terms of the context, include a plural form. Spatially relative terms (e.g., over, above, upper, under, beneath, below, lower, and so forth) are intended to encompass different orientations of the device in use or operation in addition to the orientation depicted in the figures. In some implementations, the relative terms above and below can, respectively, include vertically above and vertically below. In some implementations, the term adjacent can include laterally adjacent to or horizontally adjacent to.

Some implementations may be implemented using various semiconductor processing and/or packaging techniques. Some implementations may be implemented using various types of semiconductor processing techniques associated with semiconductor substrates including, but not limited to, for example, Silicon (Si), Gallium Arsenide (GaAs), Gallium Nitride (GaN), Silicon Carbide (SiC) and/or so forth.

While certain features of the described implementations have been illustrated as described herein, many modifications, substitutions, changes and equivalents will now occur to those skilled in the art. It is, therefore, to be understood that the appended claims are intended to cover all such modifications and changes as fall within the scope of the implementations. It should be understood that they have been presented by way of example only, not limitation, and various changes in form and details may be made. Any portion of the apparatus and/or methods described herein may be combined in any combination, except mutually exclusive combinations. The implementations described herein can include various combinations and/or subcombinations of the functions, components and/or features of the different implementations described.

While certain features of the described implementations have been illustrated as described herein, many modifications, substitutions, changes and equivalents will now occur to those skilled in the art. It is, therefore, to be understood that the appended claims are intended to cover all such modifications and changes as fall within the scope of the embodiments.

## Claims

1. A crucible for manufacturing a semiconductor crystal, comprising:
an outer wall;
an inner wall formed using a graphite membrane and defining a compartment between the inner wall and the outer wall, the graphite membrane having a porosity sufficient to enable diffusion of vapor sublimated from source powder disposed within the compartment when the source powder is sublimated by a heating element;
a first seed crystal site disposed to receive a first seed crystal; and
a second seed crystal site at an opposed end of the crucible from the first seed crystal site and disposed to receive a second seed crystal.

2. The crucible of claim 1, comprising:
a graphite filter within the crucible and positioned above the second seed crystal site when the crucible has a vertical orientation and the second seed crystal site is at a bottom of the crucible.

3. The crucible of claim 1, comprising:
a divider configured to separate the crucible into a first crucible portion and a second crucible portion.

4. The crucible of claim 3, wherein the divider includes a graphite membrane having a porosity that does not permit passage of the vapor between the first crucible portion and the second crucible portion.

5. The crucible of claim 3, wherein the crucible is detachable at the divider into a first crucible portion including the first seed crystal site and a second crucible portion including the second seed crystal site.

6. The crucible of claim 1, wherein the crucible is cylindrical.

7. A semiconductor manufacturing assembly, comprising
a heating element; and
a crucible disposed adjacent to the heating element and including a first seed crystal site and a second seed crystal site at opposed ends of the crucible, the crucible including an outer wall, the crucible further including an inner wall formed with a porous graphite membrane, wherein a compartment defined between the outer wall and the inner wall is disposed to receive source powder, which, when heated by the heating element, sublimates and diffuses from the compartment and through the inner wall to provide crystal growth of a first seed crystal at the first seed crystal site and of a second seed crystal at the second seed crystal site.

8. The semiconductor manufacturing assembly of claim 7, wherein the crucible is disposed vertically within the heating element.

9. The semiconductor manufacturing assembly of claim 7, comprising:
a divider configured to separate the crucible into a first crucible portion and a second crucible portion.

10. The semiconductor manufacturing assembly of claim 9, wherein the divider includes a graphite membrane having a porosity that does not permit passage of vapor sublimated from the source powder between the first crucible portion and the second crucible portion.

11. The semiconductor manufacturing assembly of claim 9, wherein the crucible is detachable at the divider into a first crucible portion including the first seed crystal site and a second crucible portion including the second seed crystal site.

12. The semiconductor manufacturing assembly of claim 7, comprising:
a support member positioned to support the crucible and configured to move the crucible relative to the heating element, to thereby control a temperature gradient within the crucible that occurs in response to heating provided by the heating element.

13. A method of making semiconductor crystals, comprising:
loading source powder into a compartment formed between an outer wall and an inner wall of a crucible, the inner wall being formed using a graphite membrane;
heating the source powder with a heating element to sublimate the source powder and thereby cause diffusion of the sublimated source powder through the inner wall and into at least one chamber of the crucible within the inner wall; and
monitoring crystal growth within the chamber of a first crystal from a first seed crystal positioned at a first seed crystal site and of a second crystal from a second seed crystal positioned at a second seed crystal site at an opposed end of the crucible from the first seed crystal site.

14. The method of claim 13, further comprising:
detaching a first crucible portion including the first seed crystal site from a second crucible portion including the second seed crystal site; and
loading additional source powder within a portion of the compartment included in the second crucible portion.

15. The method of claim 13, further comprising:
adjusting a temperature gradient within the crucible to re-sublimate the second crystal and enable continued growth of the first crystal.
